# EUROPEAN PATENT APPLICATION

(11) **EP 4 277 450 A1**
(43) Date of publication of application: **15.11.2023**
(21) Application number: 23171959.2
(22) Date of filing: 05.05.2023
(51) Int. Cl.: H10K 59/122, H10K 59/80, H10K 71/16, H10K 59/126

(54) **DISPLAY DEVICE AND METHOD FOR MANUFACTURING THE SAME**

(30) Priority: 09.05.2022 KR 20220056804
(71) Applicant: Samsung Display Co., Ltd., Yongin-si, Gyeonggi-do 17113 (KR)
(72) Inventor: LEE, Jeongseok, Yongin-si (KR); KIM, Seunghun, Hwaseong-si (KR); SUNG, Woo Yong, Seoul (KR)
(74) Representative: Marks & Clerk LLP

(57) **Abstract**

A display device includes a substrate, a lower metal layer disposed on the substrate, a light emitting element disposed on the lower metal layer, where the light emitting element includes a lower electrode, a light emitting layer, and an upper electrode sequentially disposed, a pixel defining layer disposed on the lower metal layer, where the pixel definining layer exposes at least a portion of the lower electrode, and a residual sacrificial layer disposed on the pixel defining layer, where portions of the upper electrode are disconnected from each other with the residual sacrificial layer therebetween.

## Description

### BACKGROUND

### 1. Field

Embodiments relate generally to display device. More particularly, embodiments relate to a display device for providing visual information and a method of manufacturing the display device.

### 2. Description of the Related Art

With the development of information technology, the importance of a display device, which is a connection medium between a user and information, has been highlighted. For example, various types of display device such as liquid crystal display device (LCD), organic light emitting display (OLED) device, plasma display panel (PDP) device, quantum dot (QD) display device or the like are widely used in various fields.

### SUMMARY

In a display device, a spacer may be disposed on a pixel defining layer to support a mask used in a process of forming a light emitting layer of the display device. However, in a manufacturing process of such a display device where the spacer that supports the mask is disposed on the pixel defining layer, dents or foreign substance penetration may occur in the spacer.

Embodiments provide a display device in which defects are effectively prevented or substantially reduced.

Embodiments provide a method of manufacturing the display device.

A display device according to embodiments of the disclosure includes a substrate, a lower metal layer disposed on the substrate, a light emitting element disposed on the lower metal layer, where the light emitting element includes a lower electrode, a light emitting layer, and an upper electrode sequentially disposed, a pixel defining layer disposed on the lower metal layer, where the pixel defining layer exposes at least a portion of the lower electrode, and a residual sacrificial layer disposed on the pixel defining layer, where portions of the upper electrode are disconnected from each other with the residual sacrificial layer therebetween.

In an embodiment, an opening may be defined through the lower metal layer to expose an upper surface of the substrate and to overlap the residual sacrificial layer.

In an embodiment, the lower metal layer may include molybdenum (Mo).

In an embodiment, the residual sacrificial layer may include a metal material.

In an embodiment, the residual sacrificial layer may include at least one selected from aluminium (Al) and silver (Ag).

In an embodiment, the upper electrode may be divided into a first portion disposed on the light emitting layer and a second portion disposed only on the pixel defining layer, and the residual sacrificial layer may be spaced apart from each of the first portion and the second portion of the upper electrode.

In an embodiment, the display device may further include a thin film encapsulation structure disposed on the residual sacrificial layer and the upper electrode, wherein the thin film encapsulation structure may include an inorganic layer.

In an embodiment, an upper surface of the residual sacrificial layer may directly contact the thin film encapsulation structure.

In an embodiment, the thin film encapsulation structure may be a single layer.

In an embodiment, the display device may further include a buffer layer disposed on the substrate and covering the lower metal layer, an inorganic insulating layer disposed on the buffer layer and an organic insulating layer disposed on the inorganic insulating layer.

In an embodiment, the inorganic insulating layer, the organic insulating layer, and the pixel defining layer may constitute an insulating structure, and a through hole may be defined through the insulating structure to be adjacent to the residual sacrificial layer.

In an embodiment, the upper electrode may extend to an upper surface of the buffer layer which is exposed through the through hole.

A method of manufacturing a display device according to embodiments of the disclosure includes providing a lower metal layer on a substrate, providing a lower electrode on the lower metal layer, providing a pixel defining layer with an opening exposing at least a portion of the lower electrode on the lower metal layer, providing a residual sacrificial layer on the pixel defining layer, providing a spacer on the residual sacrificial layer, providing a light emitting layer on the lower electrode, providing an upper electrode on the pixel defining layer, the light emitting layer and the spacer, and removing the spacer by radiating a laser to the residual sacrificial layer.

In an embodiment, portions of the upper electrode may be disconnected from each other by the spacer with a separation space formed between the residual sacrificial layer and the upper electrode.

In an embodiment, an opening may be formed through the lower metal layer to expose an upper surface of the substrate and to overlap the residual sacrificial layer.

In an embodiment, the residual sacrificial layer may be formed using a metal material.

In an embodiment, the spacer may have an undercut shape.

In an embodiment, the spacer may be formed using a negative photoresist.

In an embodiment, the laser may include at least one selected from a CO₂ laser, a green laser, an infrared laser, and an ultraviolet laser.

In an embodiment, the method may further include providing a thin film encapsulation structure including an inorganic layer on the residual sacrificial layer and the upper electrode.

At least some of the above and other features of the invention are set out in the claims.

In embodiments of a display device according to the disclosure, a residual sacrificial layer including a metal material and disconnecting an upper electrode may be disposed on a pixel defining layer. A spacer for supporting a mask used in a process of forming a light emitting layer may not be disposed directly on the residual sacrificial layer. Accordingly, the spacer on the residual sacrificial layer supports the mask, such that foreign substance penetration and dents occurring in the spacer may be effectively prevented or substantially reduced.

### BRIEF DESCRIPTION OF THE DRAWINGS

Illustrative, non-limiting embodiments will be more clearly understood from the following detailed description in conjunction with the accompanying drawings.
FIG. 1 is a plan view illustrating a display device according to an embodiment.
FIG. 2 is a cross-sectional view taken along line I-I' of FIG. 1.
FIG. 3, 4, 5, 6, 7, and 8 are cross-sectional views illustrating an embodiment of a method of manufacturing the display device of FIG. 2.
FIG. 9 is a cross-sectional view illustrating a display device according to an alternative embodiment.
FIG. 10, 11, 12, 13, 14, 15 and 16 are cross-sectional views illustrating an embodiment of a method of manufacturing the display device of FIG. 9.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the claims.

Hereinafter, a display device and a method of manufacturing the display device according to embodiments of the disclosure will be described in detail with reference to the accompanying drawings. The same reference numerals are used for the same components in the drawings, and any repetitive detailed descriptions of the same components will be omitted.

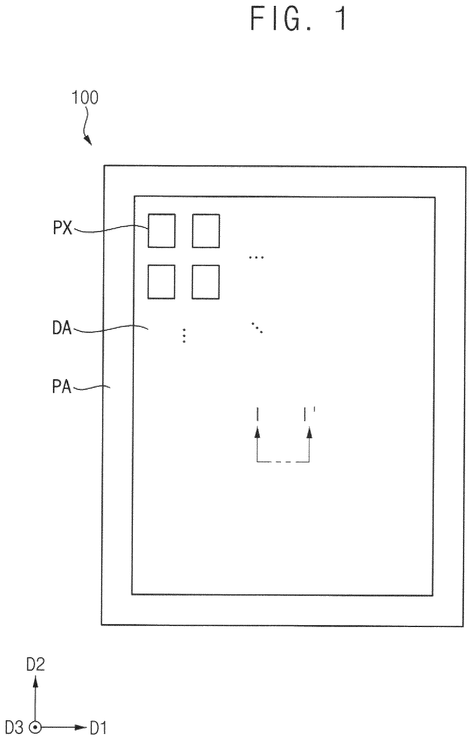

FIG. 1 is a plan view illustrating a display device according to an embodiment.

Referring to FIG. 1, a display device 100 according to an embodiment may include a display area DA and a peripheral area PA. The display area DA may be an area that displays an image by generating light or adjusting transmittance of light provided from an external light source. The peripheral area PA may be an area that does not display an image. In addition, the peripheral area PA may surround at least a portion of the display area DA. In an embodiment, for example, the peripheral area PA may entirely surround the display area DA.

A plurality of pixels PX may be arranged in the display area DA. In an embodiment, for example, each of the plurality of pixels PX may include a driving element, a light emitting element, or the like.

One pixel PX may display one predetermined basic color. That is, one pixel PX may be a minimum unit capable of displaying a color independently of other pixels PX. In an embodiment, for example, one pixel PX may display one of red, green, and blue colors.

The plurality of pixels PX may be arranged in a matrix form along a first direction D1 and a second direction D2 intersecting the first direction D 1. In an embodiment, for example, the second direction D2 may be orthogonal to the first direction D 1. Here, a third direction D3 may be a direction orthogonal to a plane defined by the first direction D1 and the second direction D2, or a thickness direction of the display device 100.

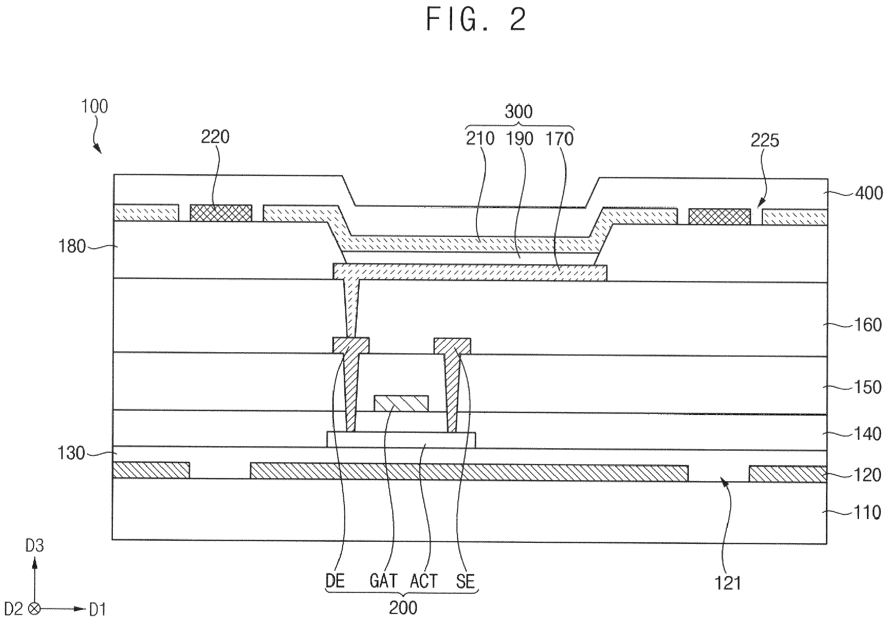

FIG. 2 is a cross-sectional view taken along line I-I' of FIG. 1. Particularly, FIG. 2 is a cross-sectional view illustrating an embodiment of the display area DA of the display device 100 of FIG. 1.

Referring to FIG. 2, the display device 100 according to an embodiment may include a substrate 110, a lower metal layer 120, a buffer layer 130, a gate insulating layer 140, a driving element 200, an interlayer insulating layer 150, a planarization layer 160, a pixel defining layer 180, a light emitting element 300, a residual sacrificial layer 220, and a thin film encapsulation structure 400.

In such an embodiment, the driving element 200 may include an active layer ACT, a gate electrode GAT, a source electrode SE, and a drain electrode DE. In such an embodiment, the light emitting element 300 may include a lower electrode 170, a light emitting layer 190, and an upper electrode 210.

The substrate 110 may include a transparent material or an opaque material. In an embodiment, for example, the substrate 110 may include or be formed of a transparent resin substrate. In such an embodiment, the transparent resin substrate may include a polyimide substrate. In such an embodiment, the polyimide substrate may include at least one selected from a first polyimide layer, a barrier film layer, a second polyimide layer, and the like. Alternatively, the substrate 110 may include a quartz substrate, a synthetic quartz substrate, a calcium fluoride substrate, a fluorine-doped quartz substrate, a soda-lime glass substrate, a non-alkali glass substrate, and the like. These may be used alone or in combination with each other.

The lower metal layer 120 may be disposed in the display area DA on the substrate 110. In an embodiment, for example, the lower metal layer 120 may include at least one selected from a metal, an alloy, a metal nitride, a conductive metal oxide, a transparent conductive material, and the like. These may be used alone or in combination with each other. In an embodiment, the lower metal layer 120 may include molybdenum ("Mo"). However, the configuration of the disclosure is not limited thereto, and the lower metal layer 120 may include other metals.

The lower metal layer 120 may block damage to a line and the light emitting layer 190 by the laser in the process of radiating the laser to the residual sacrificial layer 220. In an embodiment, an opening 121 may be defined through the lower metal layer 120 to expose an upper surface of the substrate 110 and to overlap the residual sacrificial layer 220 in the third direction D3 or in a thickness direction of the substrate 110.

The buffer layer 130 may be disposed on the substrate 110. The buffer layer 130 may sufficiently cover the lower metal layer 120. The buffer layer 130 may prevent diffusion of metal atoms or impurities from the substrate 110 to the driving element 200. In an embodiment, where a surface of the substrate 110 is not uniform, the buffer layer 130 may serve to improve the flatness of (or provide a flat or planarized surface on) the surface of the substrate 110. In an embodiment, for example, the buffer layer 130 may include at least one selected from silicon oxide, silicon nitride, and the like. These may be used alone or in combination with each other.

The active layer ACT may be disposed in the display area DA on the buffer layer 130. The active layer ACT may include a metal oxide semiconductor, an inorganic semiconductor (e.g., amorphous silicon, polysilicon), or an organic semiconductor. The active layer ACT may include a source region, a drain region, and a channel region positioned between the source region and the drain region.

The metal oxide semiconductor may include a binary compound (ABₓ), a ternary compound (ABₓC_{y}), a quaternary compound (ABₓC_{y}D_{z}), and the like containing indium (In), zinc (Zn), gallium (Ga), tin (Sn), titanium (Ti), aluminium (Al), hafnium (Hf), zirconium (Zr), magnesium (Mg), or the like. In an embodiment, for example, the metal oxide semiconductor may include zinc oxide (ZnO), gallium oxide (GaO), titanium oxide (TiO), tin oxide (SnO), indium oxide (InO), indium-gallium oxide ("IGO"), indium-zinc oxide ("IZO"), indium-tin oxide ("ITO"), gallium-zinc oxide ("GZO"), zinc-magnesium oxide ("ZMO"), zinc-tin oxide ("ZTO"), zinc-zirconium oxide (ZnZrO), indium-gallium-zinc oxide ("IGZO"), indium-zinc-tin oxide ("IZTO"), indium-gallium-hafnium oxide ("IGHO"), tin-aluminium-zinc oxide ("TAZO"), indium-gallium-tin oxide ("IGTO"), or the like. These may be used alone or in combination with each other.

The gate insulating layer 140 may be disposed on the buffer layer 130. The gate insulating layer 140 may cover the active layer ACT. The gate insulating layer 140 may sufficiently cover the active layer ACT on the buffer layer 130, and may have a substantially flat upper surface without any step structure around the active layer ACT. Alternatively, the gate insulating layer 140 may cover the active layer ACT on the buffer layer 130 and may be disposed along a profile of the active layer ACT with a uniform thickness. In an embodiment, the gate insulating layer 140 may include an inorganic insulating material. In such an embodiment, the inorganic insulating material of the gate insulating layer 140 may include at least one selected from silicon oxide (SiOx), silicon nitride (SiNx), silicon carbide (SiCx), silicon oxynitride (SiOxNy), silicon oxycarbide (SiOxCy), and the like. These may be used alone or in combination with each other.

The gate electrode GAT may be disposed in the display area DA on the gate insulating layer 140. The gate electrode GAT may overlap the channel region of the active layer ACT. In an embodiment, for example, the gate electrode GAT may include at least one selected from a metal, an alloy, a metal nitride, a conductive metal oxide, a transparent conductive material, and the like. These may be used alone or in combination with each other.

The interlayer insulating layer 150 may be disposed on the gate insulating layer 140. The interlayer insulating layer 150 may cover the gate electrode GAT. The interlayer insulating layer 150 may sufficiently cover the gate electrode GAT on the gate insulating layer 140, and may have a substantially flat upper surface without nay step structure around the gate electrode GAT. Alternatively, the interlayer insulating layer 150 may cover the gate electrode GAT on the gate insulating layer 140 and may be disposed along a profile of the gate electrode GAT with a uniform thickness. The interlayer insulating layer 150 may include an inorganic insulating material. In an embodiment, the inorganic insulating material of the interlayer insulating layer 150 may include at least one selected from silicon oxide, silicon nitride, silicon carbide, silicon oxynitride, silicon oxycarbide, and the like. These may be used alone or in combination with each other.

The source electrode SE and the drain electrode DE may be disposed in the display area DA on the interlayer insulating layer 150. The source electrode SE may be connected to the source region of the active layer ACT through a contact hole defined through the gate insulating layer 140 and the interlayer insulating layer 150 or formed by removing a first portion of the gate insulating layer 140 and the interlayer insulating layer 150. The drain electrode DE may be connected to the drain region of the active layer ACT through a contact hole defined through the gate insulating layer 140 and the interlayer insulating layer 150 or formed by removing a second portion of the gate insulating layer 140 and the interlayer insulating layer 150. In an embodiment, for example, each of the source electrode SE and the drain electrode DE may include at least one selected from a metal, an alloy, a metal nitride, a conductive metal oxide, a transparent conductive material, and the like. These may be used alone or in combination with each other.

In such an embodiment, as described above, the driving element 200 including the active layer ACT, the gate electrode GAT, the source electrode SE, and the drain electrode DE may be disposed in the display area DA on the substrate 110. In an embodiment, for example, the driving element 200 may include at least one thin film transistor.

The planarization layer 160 may be disposed on the interlayer insulating layer 150. The planarization layer 160 may sufficiently cover the source electrode SE and the drain electrode DE. In an embodiment, for example, the planarization layer 160 may have a substantially flat upper surface, and a planarization process may be additionally performed to the planarization layer 160 to implement such a flat upper surface of the planarization layer 160.

The planarization layer 160 may include an inorganic insulating material or an organic insulating material. In an embodiment, the planarization layer 160 may include an organic insulating material. In an embodiment, the organic insulating material of the planarization layer 160 may include at least one selected from photoresist, polyacrylic resin, polyimide-based resin, siloxane-based resin, acrylic-based resin, epoxy-based resin, and the like. These may be used alone or in combination with each other.

The lower electrode 170 may be disposed in the display area DA on the planarization layer 160. The lower electrode 170 may be connected to the drain electrode DE through a contact hole defined through the planarization layer 160 or formed by removing a portion of the planarization layer 160. In an embodiment, for example, the lower electrode 170 may include at least one selected from a metal, an alloy, a metal nitride, a conductive metal oxide, a transparent conductive material, and the like. These may be used alone or in combination with each other. In an embodiment, for example, the lower electrode 170 may be an anode electrode.

The pixel defining layer 180 may be disposed on the planarization layer 160. In an embodiment, an opening is defined through the pixel defining layer 180 to expose at least a portion of the lower electrode 170. The pixel defining layer 180 may include an organic insulating material or an inorganic insulating material. In an embodiment, the pixel defining layer 180 may include an organic insulating material. In an embodiment, the organic insulating material of the pixel defining layer 180 may include at least one selected from polyacrylic resin, polyimide resin, acrylic resin, phenol resin, and the like. These may be used alone or in combination with each other. Alternatively, the pixel defining layer 180 may further include a black pigment or a black dye having a high light absorption.

The light emitting layer 190 may be disposed on the lower electrode 170. In an embodiment, the light emitting layer 190 may be disposed in the opening of the pixel defining layer 180. The light emitting layer 190 may be formed using at least one selected from light emitting materials capable of emitting different color lights (i.e., red light, green light, blue light, or the like) according to sub-pixels (e.g., the pixels PX of FIG. 1). Alternatively, the light emitting layer 190 may emit white light as a whole by stacking a plurality of light emitting materials capable of generating different color lights such as red light, green light, and blue light. In such an embodiment, a color filter may be disposed on the light emitting layer 190. The color filter may include at least one selected from a red color filter, a green color filter, and a blue color filter.

The residual sacrificial layer 220 may be disposed on the pixel defining layer 180. In an embodiment, as described above, the residual sacrificial layer 220 may overlap the opening 121 of the lower metal layer 120. In such an embodiment, a remaining portion of the lower metal layer 120 except for the opening 121 may not overlap the residual sacrificial layer 220. The residual sacrificial layer 220 may disconnect or divide the upper electrode 210 into two portions. In an embodiment, the residual sacrificial layer 220 may surround the opening defined through the pixel defining layer 180 when viewed in a plan view, e.g., a top plan view or when viewed in the third direction D3.

In an embodiment, for example, the residual sacrificial layer 220 may include a metal material. In an embodiment, the residual sacrificial layer 220 may include at least one selected from aluminium (Al), silver (Ag), and the like. These may be used alone or in combination with each other. However, the configuration of the invention is not limited thereto, and the residual sacrificial layer 220 may include other metal materials.

The upper electrode 210 may be disposed on the light emitting layer 190 and the pixel defining layer 180. In an embodiment, the upper electrode 210 may be disconnected by the residual sacrificial layer 220. In an embodiment, for example, the upper electrode 210 may include at least one selected from a metal, an alloy, a metal nitride, a conductive metal oxide, a transparent conductive material, and the like. These may be used alone or in combination with each other.

In an embodiment, the upper electrode 210 may be divided into a first portion disposed on the light emitting layer 190 and a second portion spaced apart from the first portion with the residual sacrificial layer 220 therebetween. The second portion may be a portion disposed only on the pixel defining layer 180. In such an embodiment, a separation space 225 may be defined or formed between the upper electrode 210 and the residual sacrificial layer 220. In such an embodiment, each of the first portion and the second portion of the upper electrode 210 may be spaced apart from the residual sacrificial layer 220.

In a process of manufacturing the display device 100, a spacer for supporting a mask used in a process of forming the light emitting layer 190 may be formed on the residual sacrificial layer 220, and the spacer may be removed by radiating a laser to the residual sacrificial layer 220. In an embodiment, as the upper electrode 210 is disconnected by the residual sacrificial layer 220, the formation of burrs on the upper electrode 210 may be prevented by radiating the laser to the residual sacrificial layer 220.

Accordingly, the light emitting element 300 including the lower electrode 170, the light emitting layer 190, and the upper electrode 210 may be disposed in the display area DA on the substrate 110.

In an embodiment, a capping layer (not shown) may be disposed on the upper electrode 210. The capping layer may protect the light emitting element 300. In such an embodiment, the capping layer may be disconnected by the residual sacrificial layer 220. That is, the capping layer may be divided into a portion overlapping the light emitting layer 190 by the residual sacrificial layer 220 and a portion disposed only on the pixel defining layer 180.

The capping layer may include an organic insulating material or an inorganic insulating material. In an embodiment, for example, the capping layer may include an organic insulating material such as triamine derivative, arylenediamine derivative, 4'4'-N'N' triamine derivative, arylenediamine derivative, 4'4'-N'N'-dicarbazole-biphenyl ("CBP"), tris-8-hydroxyquinoline aluminium ("Alq₃"), or the like. These may be used alone or in combination with each other.

The thin film encapsulation structure 400 may be disposed on the residual sacrificial layer 220 and the upper electrode 210. The thin film encapsulation structure 400 may prevent the light emitting element 300 from being deteriorated due to penetration of moisture, oxygen, or the like. In addition, the thin film encapsulation structure 400 may also perform a function of protecting the light emitting element 300 from external impact. In an embodiment, for example, the thin film encapsulation structure 400 may include an inorganic layer. The inorganic layer may include inorganic materials having flexibility. In an embodiment, the thin film encapsulation structure 400 may be a single layer. However, the configuration of the invention is not limited thereto, and the thin film encapsulation structure 400 may have a multi-layered structure.

In an embodiment, the thin film encapsulation structure 400 may directly contact or be disposed directly on the upper surface of the residual sacrificial layer 220. That is, no configuration or element may be disposed between the thin film encapsulation structure 400 and the residual sacrificial layer 220. In such an embodiment, the spacer for supporting a mask used in the process of forming the light emitting layer 190 may not be disposed between the thin film encapsulation structure 400 and the residual sacrificial layer 220 by being removed before providing the thin film encapsulation structure 400 on the upper surface of the residual sacrificial layer 220 in a manufacturing process.

In a case, the spacer may be disposed directly on the pixel defining layer 180 to support a mask used in the process of forming the light emitting layer 190, and the mask may be disposed on the spacer to be supported. In this case, foreign substances and dents may occur in the spacer due to the mask.

In the display device 100 according to an embodiment of the disclosure, the residual sacrificial layer 220 including a metal material and disconnecting the upper electrode 210 may be disposed on the pixel defining layer 180. In such an embodiment, the spacer may not be disposed directly on the residual sacrificial layer 220. Accordingly, as the spacer on the residual sacrificial layer 220 supports the mask, foreign substance penetration or dents occurring in the spacer may be effectively prevented or substantially reduced.

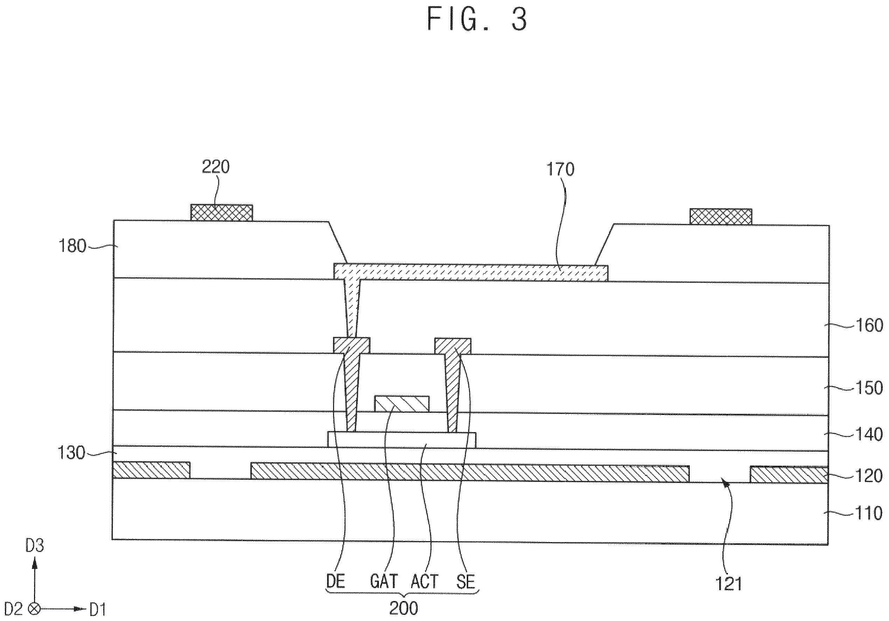

FIG. 3, 4, 5, 6, 7, and 8 are cross-sectional views illustrating an embodiment of a method of manufacturing the display device of FIG. 2.

Referring to FIG. 3, a metal layer may be provided or formed in the display area DA on the substrate 110 including a transparent material or an opaque material. In an embodiment, for example, the metal layer may be formed using a metal, an alloy, a metal nitride, a conductive metal oxide, a transparent conductive material, or the like.

The opening 121 exposing the upper surface of the substrate 110 may be formed through the metal layer by removing a portion of the metal layer. Accordingly, the lower metal layer 120 with the opening 121 defined therethrough to overlap the residual sacrificial layer 220 may be provided or formed on the substrate 110.

The buffer layer 130 may be provided or formed on the substrate 110. The buffer layer 130 may be formed to sufficiently cover the lower metal layer 120. In an embodiment, for example, the buffer layer 130 may be formed using silicon oxide, silicon nitride, or the like.

The active layer ACT may be provided or formed in the display area DA on the buffer layer 130. The active layer ACT may include a metal oxide semiconductor, an inorganic semiconductor, or an organic semiconductor. The active layer ACT may include a source region, a drain region, and a channel region positioned between the source region and the drain region.

The gate insulating layer 140 may be provided or formed on the buffer layer 130. The gate insulating layer 140 may be formed to cover the active layer ACT. In an embodiment, for example, the gate insulating layer 140 may be formed using silicon oxide, silicon nitride, silicon carbide, silicon oxynitride, silicon oxycarbide, or the like.

The gate electrode GAT may be provided or formed in the display area DA on the gate insulating layer 140. The gate electrode GAT may be formed to overlap the active layer ACT. In an embodiment, for example, the gate electrode GAT may be formed using a metal, an alloy, a metal nitride, a conductive metal oxide, a transparent conductive material, or the like.

The interlayer insulating layer 150 may be provided or formed on the gate insulating layer 140. The interlayer insulating layer 150 may be formed to cover the gate electrode GAT. In an embodiment, for example, the interlayer insulating layer 150 may be formed using silicon oxide, silicon nitride, silicon carbide, silicon oxynitride, silicon oxycarbide, or the like.

A first contact hole exposing the source region of the active layer ACT may be formed through the gate insulating layer 140 and the interlayer insulating layer 150 by removing the first portions of the gate insulating layer 140 and the interlayer insulating layer 150. A second contact hole exposing the drain region of the active layer ACT may be formed through the gate insulating layer 140 and the interlayer insulating layer 150 by removing the second portion of the gate insulating layer 140 and the interlayer insulating layer 150. The first contact hole and the second contact hole may be simultaneously formed or formed during a same process.

The source electrode SE may be provided or formed to be connected to the source region of the active layer ACT through the first contact hole. The drain electrode DE may be formed to be connected to the drain region of the active layer ACT through the second contact hole. In an embodiment, for example, each of the source electrode SE and the drain electrode DE may be formed using a metal, an alloy, a metal nitride, a conductive metal oxide, a transparent conductive material, or the like.

The planarization layer 160 may be provided or formed on the interlayer insulating layer 150. The planarization layer 160 may be formed to sufficiently cover the source electrode SE and the drain electrode DE. In an embodiment, for example, the planarization layer 160 may be formed using a photoresist, a polyacrylic resin, a polyimide-based resin, a siloxane-based resin, an acrylic resin, an epoxy-based resin, or the like.

The lower electrode 170 may be provided or formed in the display area DA on the planarization layer 160. The lower electrode 170 may be connected to the drain electrode DE through a contact hole formed through the planarization layer 160 by removing a portion of the planarization layer 160. In an embodiment, for example, the lower electrode 170 may be formed using a metal, an alloy, a metal nitride, a conductive metal oxide, a transparent conductive material, or the like.

The pixel defining layer 180 may be provided or formed in the display area DA on the planarization layer 160. The pixel defining layer 180 may be formed to expose a portion of the upper surface of the lower electrode 170. In an embodiment, for example, the pixel defining layer 180 may be formed using an organic insulating material.

The residual sacrificial layer 220 may be provided or formed on the pixel defining layer 180. In an embodiment, the residual sacrificial layer 220 may be formed to overlap the opening 121 of the lower metal layer 120. In an embodiment, for example, the residual sacrificial layer 220 may be formed using a metal material such as aluminium or silver.

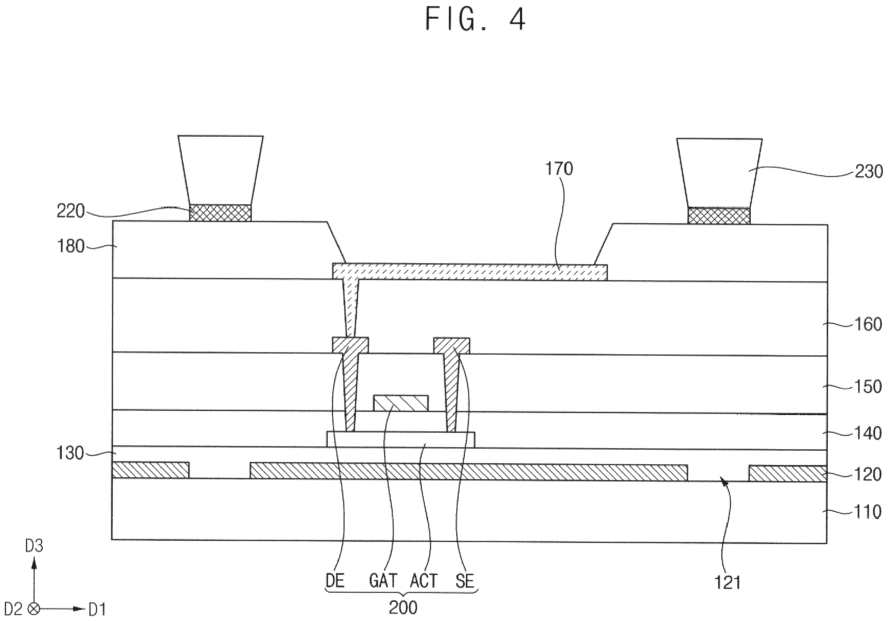

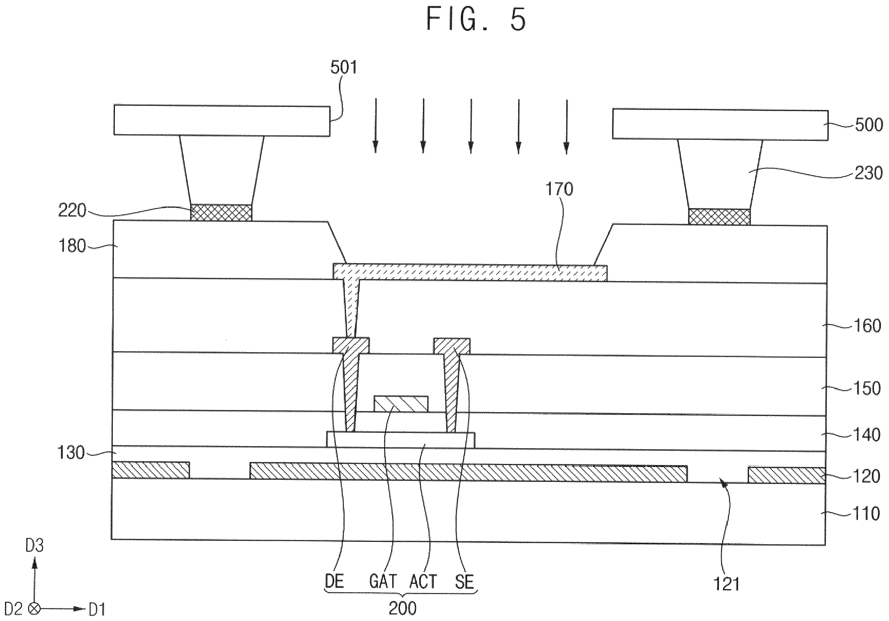

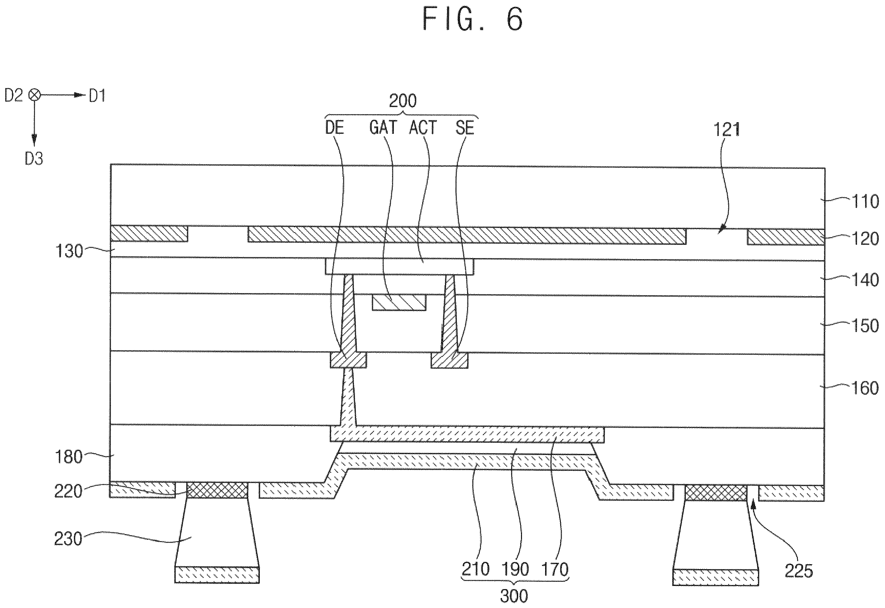

Referring to FIG. 4, the spacer 230 may be formed on the residual sacrificial layer 220. The spacer 230 may serve to support a mask (e.g., a mask 500 of FIG. 5) used in a process of forming the light emitting layer (e.g., the light emitting layer 190 of FIG. 6). In an embodiment, the spacer 230 may have an undercut shape.

The spacer 230 may be formed using photoresist. In an embodiment, the spacer 230 may be formed using a negative photoresist. In such an embodiment where the spacer 230 uses a negative photoresist, the spacer 230 may have an undercut shape.

Referring to FIG. 5, the mask 500 with an opening 501 may be positioned on the spacer 230. In an embodiment, the mask 500 may be in contact with the upper surface of the spacer 230. In such an embodiment, the opening 501 of the mask 500 may be positioned to overlap the lower electrode 170. The spacer 230 may serve to support the mask 500 in the process of forming the light emitting layer 190. In an embodiment, for example, the mask 500 may be a fine metal mask ("FMM").

The light emitting layer 190 may be formed on the lower electrode 170 using the mask 500. The light emitting layer 190 may be formed using at least one selected from light emitting materials capable of emitting different color lights (i.e., red light, green light, blue light, or the like) according to the sub-pixels (e.g., the pixels PX of FIG. 1).

Referring to FIG. 6, a display device illustrated in FIG. 5 may be turned upside down. Next, the upper electrode 210 may be provided or formed on the pixel defining layer 180 and the spacer 230. In an embodiment, for example, the upper electrode 210 may be formed using a metal, an alloy, a metal nitride, a conductive metal oxide, a transparent conductive material, or the like.

In the process of forming the upper electrode 210, the upper electrode 210 may be disconnected by the spacer 230. In such an embodiment, the upper electrode 210 may be disconnected by the spacer 230 that overlaps the separation space 225 between the residual sacrificial layer 220 and the upper electrode 210. Accordingly, the upper electrode 210 may be divided into a portion disposed on the light emitting layer 190, a portion disposed only on the pixel defining layer 180, and a portion disposed only on the spacer 230.

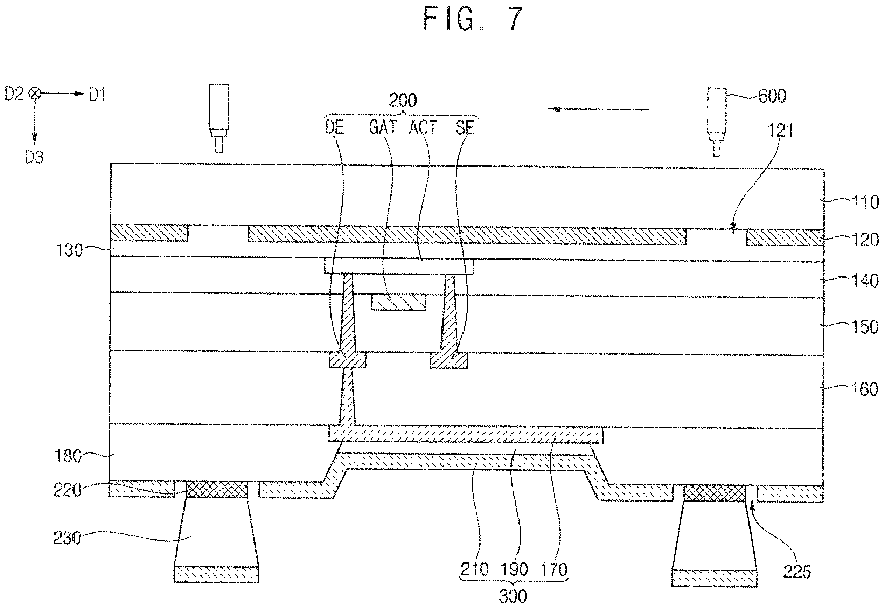

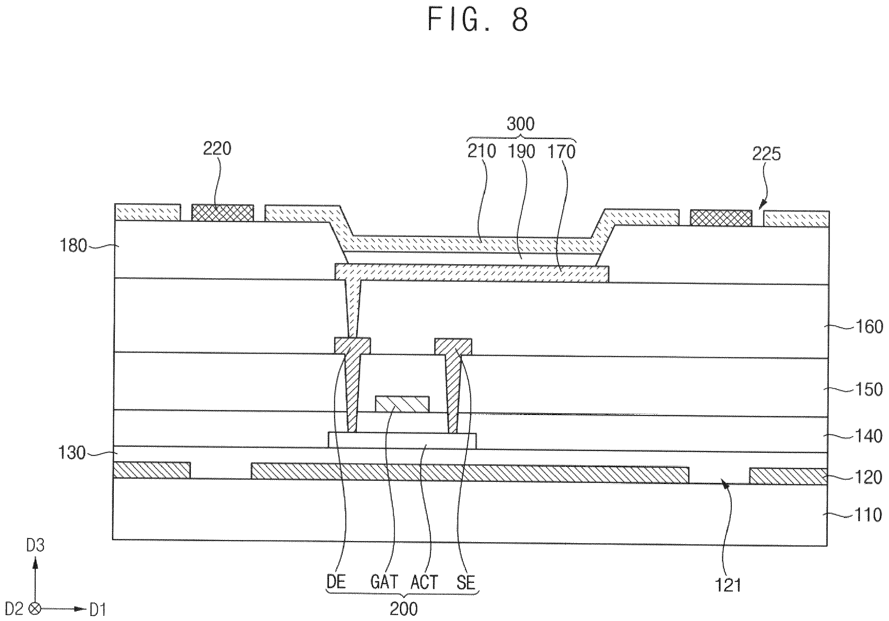

Referring to FIGS. 7 and 8, a laser may be radiated to the residual sacrificial layer 220 using a laser apparatus 600. In an embodiment, the laser apparatus 600 may radiate a laser to the residual sacrificial layer 220 through a scan method. In an embodiment, for example, the laser may be at least one selected from a CO₂ laser, a green laser, an infrared laser, and an ultraviolet laser. By radiating the laser to the residual sacrificial layer 220 using the laser apparatus 600, the spacer 230 may be removed. In this case, a portion of the upper electrode 210 disposed on the spacer 230 may also be removed. A display device illustrated in FIG. 7 may be turned over again in a position as a display device illustrated in FIG. 8 after the spacer 230 is removed.

Referring back to FIG. 2, the thin film encapsulation structure 400 may be provided or formed on the residual sacrificial layer 220 and the upper electrode 210. The thin film encapsulation structure 400 may include an inorganic layer formed using inorganic materials having flexibility. In an embodiment, for example, the thin film encapsulation structure 400 may be formed as a single layer including an inorganic material.

Accordingly, the display device 100 illustrated in FIG. 2 may be manufactured.

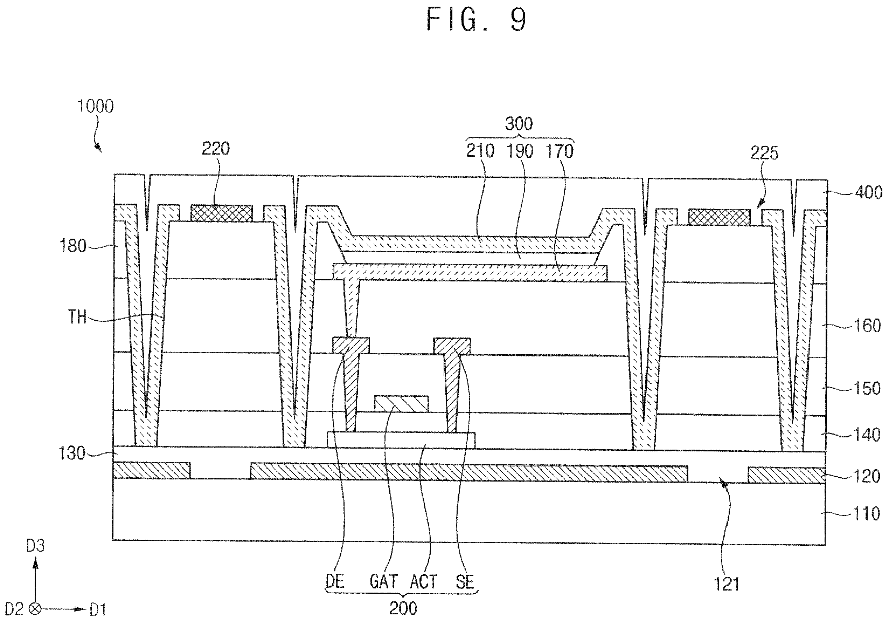

FIG. 9 is a cross-sectional view illustrating a display device according to an alternative embodiment.

Referring to FIG. 9, a display device 1000 according to an embodiment may include a substrate 110, a lower metal layer 120, a buffer layer 130, a gate insulating layer 140, a driving element 200, an interlayer insulating layer 150, a planarization layer 160, a pixel defining layer 180, a light emitting element 300, a residual sacrificial layer 220, and a thin film encapsulation structure 400. In such an embodiment, the driving element 200 may include an active layer ACT, a gate electrode GAT, a source electrode SE, and a drain electrode DE, and the light emitting element 300 may include a lower electrode 170, a light emitting layer 190, and an upper electrode 210. Hereinafter, any repetitive detailed descriptions of the same or like elements of the display device 1000 shown in FIG. 9 as those of the display device 100 described above with reference to FIG. 2 will be omitted or simplified.

The gate insulating layer 140, the interlayer insulating layer 150, the planarization layer 160, and the pixel defining layer 180 may constitute an insulating structure. In an embodiment, the gate insulating layer 140 may be an inorganic insulating layer, and each of the interlayer insulating layer 150 and the planarization layer 160 may an organic insulating layer.

In an embodiment, at least one through hole TH may be defined through the insulating structure to expose the upper surface of the buffer layer 130. In such an embodiment, the through hole TH may be adjacent to the residual sacrificial layer 220.

The upper electrode 210 may be disposed on the light emitting layer 190 and the pixel defining layer 180. The upper electrode 210 may be disconnected by the residual sacrificial layer 220. The upper electrode 210 may extend to the upper surface of the buffer layer 130 exposed by the through hole TH of the insulating structure.

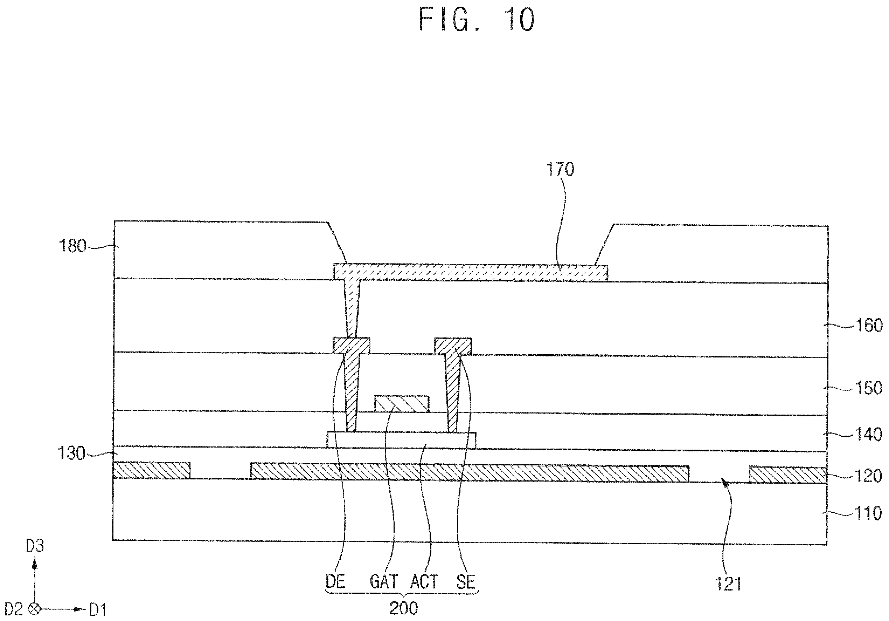

FIG. 10, 11, 12, 13, 14, 15 and 16 are cross-sectional views illustrating an embodiment of a method of manufacturing the display device of FIG. 9.

Hereinafter, any repetitive detailed descriptions of the same or like elements of the method of manufacturing the display device of FIG. 9 as those of the manufacturing method of the display device 100 of FIG. 2 described above with reference to FIGS. 3, 4, 5, 6, 7, and 8 will be omitted or simplified.

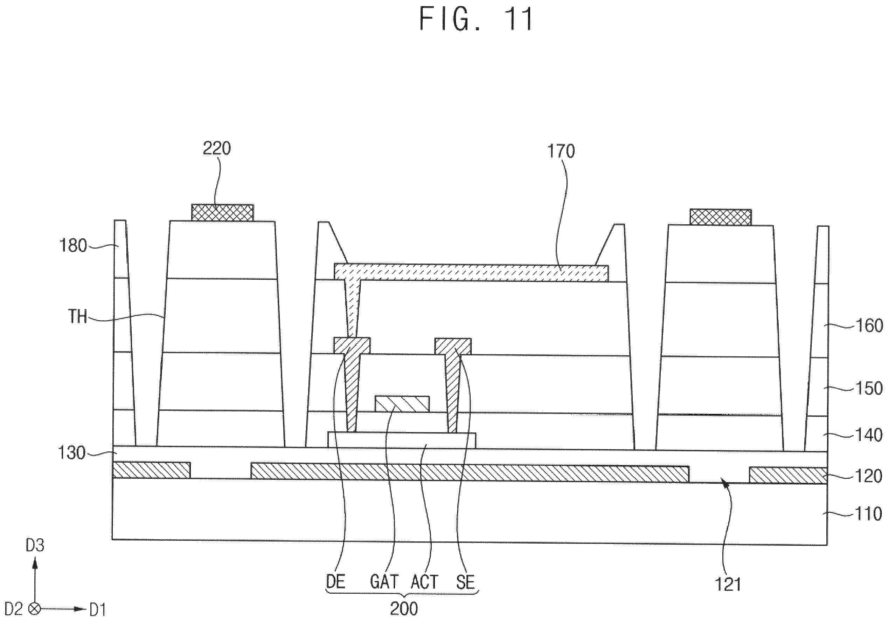

Referring to FIGS. 10 and 11, the lower metal layer 120, the buffer layer 130, the active layer ACT, the gate insulating layer 140, the gate electrode GAT, the interlayer insulating layer 150, the source electrode SE, the drain electrode DE, the planarization layer 160, the lower electrode 170, and the pixel defining layer 180 may be sequentially provided or formed on the substrate 110 including a transparent material or an opaque material.

The residual sacrificial layer 220 may be provided or formed on the pixel defining layer 180. The residual sacrificial layer 220 may be formed to overlap the opening 121 of the lower metal layer 120. In an embodiment, for example, the residual sacrificial layer 220 may be formed using a metal material.

The gate insulating layer 140, the interlayer insulating layer 150, the planarization layer 160, and the pixel defining layer 180 may constitute an insulating structure. At least one through hole TH exposing the upper surface of the buffer layer 130 may be formed through the insulating structure by removing a portion of the insulating structure. The through hole TH may be formed adjacent to the residual sacrificial layer 220.

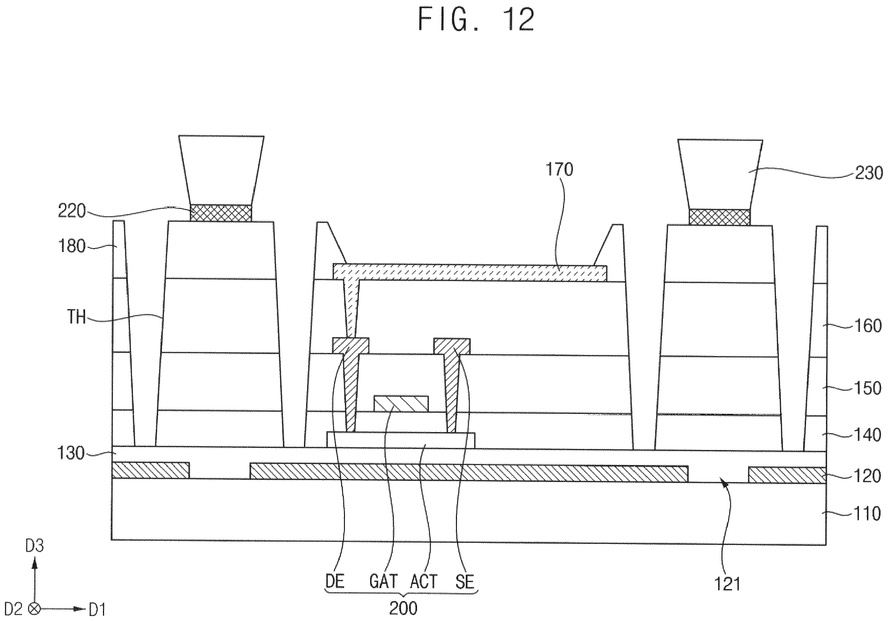

Referring to FIG. 12, the spacer 230 may be provided or formed on the residual sacrificial layer 220. In an embodiment, the spacer 230 may have an undercut shape. The spacer 230 may be formed using photoresist. In an embodiment, for example, the spacer 230 may be formed using negative photoresist. In such an embodiment where the spacer 230 is formed using a negative photoresist, the spacer 230 may have an undercut shape.

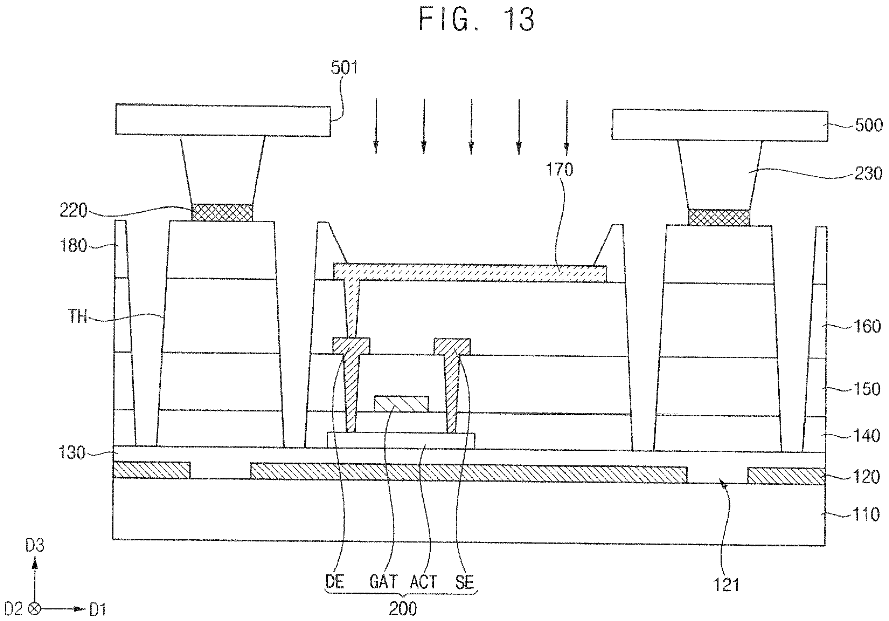

Referring to FIG. 13, a mask 500 with an opening 501 may be positioned on the spacer 230. The opening 501 of the mask 500 may be positioned to overlap the lower electrode 170. The light emitting layer 190 may be formed on the lower electrode 170 using the mask 500. The light emitting layer 190 may be formed using at least one selected from light emitting materials capable of emitting red light, green light, blue light, and the like.

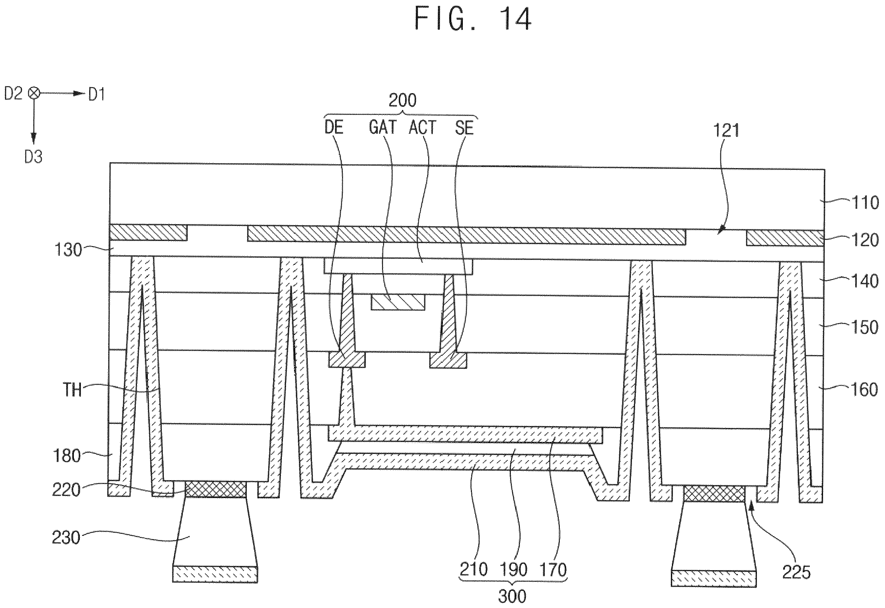

Referring to FIG. 14, a display device illustrated in FIG. 13 may be turned upside down. Next, the upper electrode 210 may be provided or formed on the pixel defining layer 180 and the spacer 230. The upper electrode 210 may extend to the upper surface of the buffer layer 130 exposed by the through hole TH.

In the process of forming the upper electrode 210, the upper electrode 210 may be disconnected by the spacer 230. Accordingly, the upper electrode 210 may be divided into a portion disposed on the light emitting layer 190, a portion disposed only on the pixel defining layer 180, and a portion disposed only on the spacer 230.

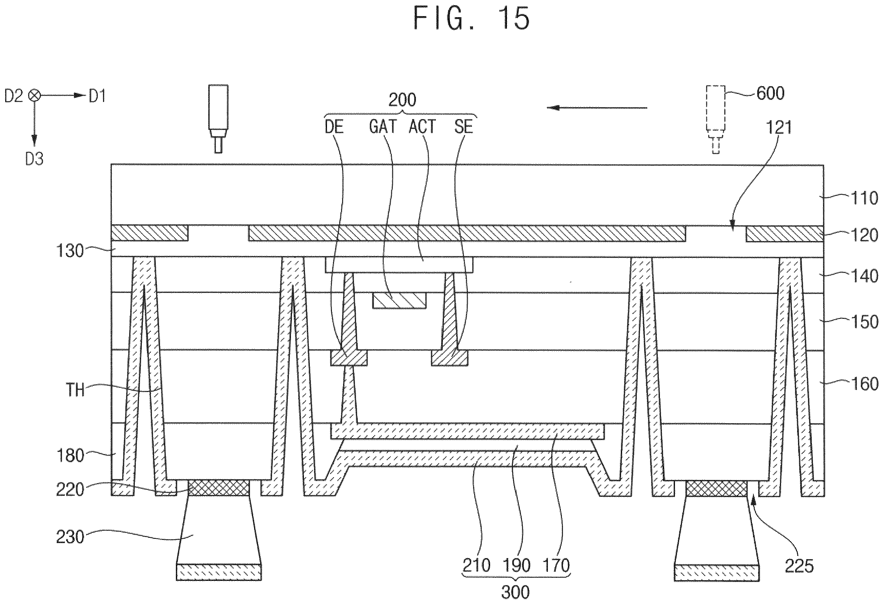

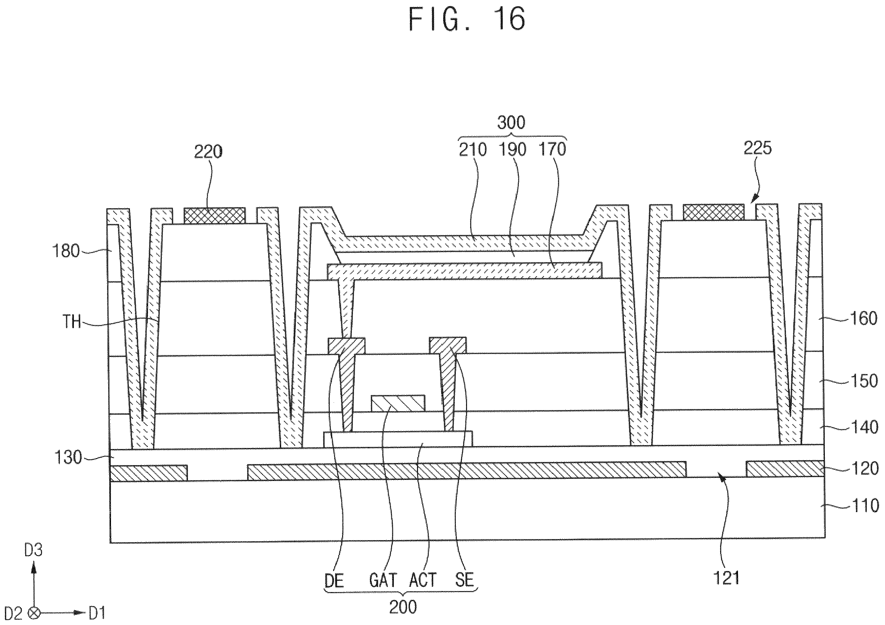

Referring to FIGS. 15 and 16, the laser may be radiated to the residual sacrificial layer 220 in a scan manner using a laser apparatus 600. As the laser is radiated to the residual sacrificial layer 220, the spacer 230 may be removed. In this case, heat generated in the residual sacrificial layer 220 due to the laser may affect the light emitting element 300.

In an embodiment where at least one through hole TH is defined through the insulating structure to be adjacent to the residual sacrificial layer 220, and the upper electrode 210 extends to the upper surface of the buffer layer 130 exposed by the through hole TH of the insulating structure, the effect of heat generated from the residual sacrificial layer 220 on the light emitting element 300 due to the laser may be reduced.

A display device illustrated in FIG. 15 may be turned again in a position as a display device illustrated in FIG. 16 after the spacer 230 is removed.

Referring back to FIG. 9, the thin film encapsulation structure 400 including an inorganic layer may be provided or formed on the residual sacrificial layer 220 and the upper electrode 210. In an embodiment, for example, the thin film encapsulation structure 400 may be formed as a single layer including an inorganic material.

Accordingly, the display device 1000 illustrated in FIG. 9 may be manufactured.

Embodiments of the disclosure may be applied to various display devices. In an embodiment, for example, the disclosure is applicable to various display devices such as display devices for vehicles, ships and aircraft, portable communication devices, display devices for exhibition or information transmission, medical display devices, and the like.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a substrate;
a lower metal layer disposed on the substrate;
a light emitting element disposed on the lower metal layer, wherein the light emitting element includes a lower electrode, a light emitting layer, and an upper electrode sequentially disposed;
a pixel defining layer disposed on the lower metal layer, wherein the pixel defining layer exposes at least a portion of the lower electrode; and
a residual sacrificial layer disposed on the pixel defining layer, wherein portions of the upper electrode are disconnected from each other with the residual sacrificial layer therebetween.

2. The display device of claim 1, wherein an opening is defined through the lower metal layer to expose an upper surface of the substrate and to overlap the residual sacrificial layer.

3. The display device of claim 1 or claim 2, wherein the lower metal layer includes molybdenum (Mo).

4. The display device of any one of claims 1 to 3, wherein the residual sacrificial layer includes a metal material, optionally wherein the residual sacrificial layer includes at least one selected from aluminium (Al) and silver (Ag).

5. The display device of any one of claims 1 to 4, wherein the upper electrode is divided into a first portion disposed on the light emitting layer and a second portion disposed only on the pixel defining layer, and
wherein the residual sacrificial layer is spaced apart from each of the first portion and the second portion of the upper electrode.

6. The display device of any one of claims 1 to 5, further comprising:
a thin film encapsulation structure disposed on the residual sacrificial layer and the upper electrode, wherein the thin film encapsulation structure includes an inorganic layer.

7. The display device of claim 6, wherein an upper surface of the residual sacrificial layer directly contacts the thin film encapsulation structure.

8. The display device of claim 6 or claim 7, wherein the thin film encapsulation structure is a single layer.

9. The display device of any one of claims 1 to 8, further comprising:
a buffer layer disposed on the substrate and covering the lower metal layer;
an inorganic insulating layer disposed on the buffer layer; and
an organic insulating layer disposed on the inorganic insulating layer.

10. The display device of claim 9, wherein the inorganic insulating layer, the organic insulating layer, and the pixel defining layer constitute an insulating structure, and
wherein a through hole is defined through the insulating structure to be adjacent to the residual sacrificial layer, optionally wherein the upper electrode extends to an upper surface of the buffer layer which is exposed through the through hole.

11. A method of manufacturing a display device, the method comprising:
providing a lower metal layer on a substrate;
providing a lower electrode on the lower metal layer;
providing a pixel defining layer with an opening exposing at least a portion of the lower electrode on the lower metal layer;
providing a residual sacrificial layer on the pixel defining layer;
providing a spacer on the residual sacrificial layer;
providing a light emitting layer on the lower electrode;
providing an upper electrode on the pixel defining layer, the light emitting layer and the spacer; and
removing the spacer by radiating a laser to the residual sacrificial layer.

12. The method of claim 11, wherein portions of the upper electrode are disconnected by the spacer with a separation space formed between the residual sacrificial layer and the upper electrode.

13. The method of claim 11 or claim 12, wherein an opening is formed through the lower metal layer to expose an upper surface of the substrate and to overlap the residual sacrificial layer.

14. The method of any one of claims 11 to 13, wherein:
(i) the residual sacrificial layer is formed using a metal material; and/or
(ii) the spacer has an undercut shape; and/or
(iii) the spacer is formed using a negative photoresist; and/or
(iv) the laser is at least one selected from a CO₂ laser, a green laser, an infrared laser, and an ultraviolet laser.

15. The method of any one of claims 11 to 14, further comprising:
providing a thin film encapsulation structure including an inorganic layer on the residual sacrificial layer and the upper electrode.
